# EUROPEAN PATENT APPLICATION

(11) **EP 3 790 054 A1**
(43) Date of publication of application: **10.03.2021**
(21) Application number: 20193524.4
(22) Date of filing: 31.08.2020
(51) Int. Cl.: H01L 27/32, H01L 51/52

(54) **ORGANIC LIGHT EMITTING DISPLAY DEVICE AND METHOD OF MANUFACTURING THE SAME**

(30) Priority: 04.09.2019 KR 20190109626
(71) Applicant: Samsung Display Co., Ltd., Yongin-si Gyeonggi-do 17113 (KR)
(72) Inventor: CHOI, Nakcho, 123-1106 Gyeonggi-do (KR); NAM, Kie Hyun, 102-203 Gyeonggi-do (KR); KWEON, Dae-Gi, 1601-1201 Gyeonggi-do (KR); RYU, Min Yeul, 205 Gyeonggi-do (KR)
(74) Representative: Dr. Weitzel & Partner

(57) **Abstract**

An organic light emitting display device includes a via pattern including a first surface parallel to a top surface of a substrate and a second surface being inclined with respect to the top surface of the substrate at a predetermined angle, a first electrode disposed on the via pattern and including an inclined portion which has an end portion being toward the substrate, and a black matrix located on the second electrode.

## Description

### TECHNICAL FIELD

Example embodiments of the present inventive concept relate generally to an organic light emitting display device and a method of manufacturing the same, and more particularly, to an organic light emitting display device including a first electrode and a method of manufacturing the same.

### DISCUSSION OF RELATED ART

Among flat panel display devices, an organic light emitting display device has attracted significant attention because of its relatively thin, light, low power consumption, and fast response speed. The organic light emitting display device may include a plurality of pixels to display an image, with each pixel including a lower electrode, an upper electrode, and a light emitting layer interposed between the lower electrode and the upper electrode. The lower electrode may be divided into a central portion and an end portion (or an outmost portion) located at both sides of the central portion. The light emitting layer is disposed on the central portion of the lower electrode, and the upper electrode is disposed on the light emitting layer. A voltage may be applied to the lower electrode and the upper electrode, so that a light having a predetermined color (e.g., a red, a green, or a blue color) may be emitted from the light emitting layer.

As a light incident from outside (e.g., an external light) is reflected from the lower electrode, a color of the light (for example, the light having a predetermined color) emitted from the light emitting layer may be blurred. In particular, the color of the light emitted from the light emitting layer may be blurred by the external light reflected from the end portion of the lower electrode on which the light emitting layer is not disposed. Furthermore, the external light reflected from the end portion of the lower electrode on which the light emitting layer is not disposed reduces a brightness of the image displayed by the organic light emitting display device, and a lifetime of the light emitting layer may be reduced by supplying higher voltage to increase the brightness.

### SUMMARY

Example embodiments of the present inventive concept provide an organic light emitting display device and a method of manufacturing the same.

According to an example embodiment of the present inventive concept, the organic light emitting display device may include a substrate, a via pattern disposed on the substrate, the via pattern including a first surface parallel to a top surface of the substrate and a second surface located at both sides of the first surface, the second surface being inclined with respect to the top surface of the substrate at a predetermined angle, a first electrode disposed on the first and second surfaces of the via pattern, the first electrode including an inclined portion overlapping with the second surface of the via pattern, with an end portion of the inclined portion being toward the substrate, a light emitting layer disposed on the first electrode, a second electrode disposed on the light emitting layer and a black matrix located on the second electrode.

In an example embodiment of the present inventive concept, the predetermined angle may be set such that an external light reflected from the inclined portion is incident on the black matrix.

In an example embodiment of the present inventive concept, the predetermined angle may be an acute angle.

In an example embodiment of the present inventive concept, the via pattern may further include a third surface located opposite to the first surface, and a length of the first surface may be shorter than a length of the third surface.

In an example embodiment of the present inventive concept, a cross-sectional shape of the via pattern may be a trapezoidal shape.

In an example embodiment of the present inventive concept, the organic light emitting display device may further include a first pixel defining layer disposed on the first electrode, including a first opening which is exposing a first part of the first electrode, and absorbing an external light.

In an example embodiment of the present inventive concept, the organic light emitting display device may further include a second pixel defining layer interposed between the first pixel defining layer and the second electrode such that the first pixel defining layer is spaced apart from the second electrode, including a second opening which is exposing a second part of the first electrode, and transmitting the external light.

In an example embodiment of the present inventive concept, a width of the second opening may be smaller than a width of the first opening.

In an example embodiment of the present inventive concept, the second pixel defining layer may overlap with at least a part of the inclined portion of the first electrode, and the predetermined angle may be set such that the external light reflected from the inclined portion is incident on the black matrix through the second pixel defining layer.

In an example embodiment of the present inventive concept, the black matrix may not overlap with the first electrode.

In an example embodiment of the present inventive concept, the organic light emitting display device may further include a color filter layer overlapping with the light emitting layer, with the color filter layer disposed on the second electrode.

In an example embodiment of the present inventive concept, the light emitting layer may emit a white light.

In an example embodiment of the present inventive concept, the first electrode may include a reflective electrode, and the second electrode may include a transparent electrode.

In an example embodiment of the present inventive concept, the organic light emitting display device may further include a protecting layer disposed between the substrate and the via pattern, and including an inorganic insulation material.

According to an example embodiment of the present inventive concept, a method of manufacturing an organic light emitting display device may include preparing a substrate, forming a via pattern on the substrate to include a first surface parallel to a top surface of the substrate and a second surface located at both sides of the first surface, the second surface being inclined with respect to the top surface of the substrate at a predetermined angle, forming a first electrode overlapped with the second surface, the first electrode disposed on the first and second surfaces of the via pattern and including an inclined portion, with an end portion of the inclined portion being toward the substrate, forming a light emitting layer on the first electrode, forming a second electrode on the light emitting layer, and forming a black matrix on the second electrode.

In an example embodiment of the present inventive concept, the predetermined angle may be set such that an external light reflected from the inclined portion is incident on the black matrix.

In an example embodiment of the present inventive concept, the method of manufacturing an organic light emitting display device may further include forming a first pixel defining layer on the first electrode to include a first opening which is exposing a part of the first electrode, and forming a second pixel defining layer on the first pixel defining layer to include a second opening which is overlapping with the first opening after the forming of the first electrode.

In an example embodiment of the present inventive concept, the first pixel defining layer may absorb an external light, the second pixel defining layer may transmit the external light, and a width of the second opening may be smaller than a width of the first opening.

In an example embodiment of the present inventive concept, the method of manufacturing an organic light emitting display device may further include forming a protecting layer on the substrate after the preparing of the substrate.

In an example embodiment of the present inventive concept, the method of manufacturing an organic light emitting display device may further include forming a contact hole on the protecting layer prior to the forming of the via pattern.

According to an example embodiment of the present inventive concept, the organic light emitting display device may include a substrate, a first electrode disposed on the substrate and including a horizontal top surface in parallel with a top surface of the substrate, and two inclined side surfaces respectively located at two opposite sides of the horizontal top surface of the first electrode, each of the two inclined side surfaces being inclined with respect to the top surface of the substrate at a predetermined angle and extending from the horizontal top surface of the first electrode with an end portion toward the substrate, a light emitting layer disposed on the first electrode, a second electrode disposed on the light emitting layer, and a black matrix located on the second electrode and not overlapped with the first electrode.

In an example embodiment of the present inventive concept, the predetermined angle may be set such that an external light reflected from each of the two inclined side surfaces of the first electrode is incident on the black matrix.

Since the organic light emitting display device according to an example embodiment of the present inventive concept includes the via pattern including the second surface inclined at the predetermined angle, the first electrode disposed on the second surface of the via pattern and including the inclined portion toward the substrate, the external light reflected from the inclined portion of the first electrode may be incident on the black matrix and may be blocked by the black matrix. Accordingly, a color of light emitted from the light emitting layer may be more clearly seen by a user. In addition, since the organic light emitting display device does not include a polarizer and/or a phase retarder, a weight and a thickness of the organic light emitting display device may be reduced. In addition, the light emitted from the light emitting layer is visually recognized more brightly. Therefore, a deterioration of the light emitting layer may be prevented by reducing an amount of current supplied to the light emitting layer, so that a lifetime of the light emitting layer may be further increased.

Since the method of manufacturing the organic light emitting display device may include the forming of the via pattern including the second surface that is inclined at the predetermined angle, and the forming of the first electrode including the inclined portion toward the substrate, the external light reflected from the inclined portion of the first electrode may be incident on the black matrix and may be blocked by the black matrix. Accordingly, the organic light emitting display device formed through the method may have the above effects. In addition, the method may reduce a manufacturing cost by not including a process of forming the polarizer and/or the phase retarder.

### BRIEF DESCRIPTION OF THE DRAWINGS

Illustrative and non-limiting example embodiments of the present inventive concept will be more clearly understood from the following detailed description in conjunction with the accompanying drawings, in which:
FIG. 1 is a plan view illustrating an organic light emitting display device according to an example embodiment of the present inventive concept;
FIG. 2 is a cross-sectional view taken along line I-I' of FIG. 1;
FIG. 3 is a flowchart illustrating a method of manufacturing an organic light emitting display device according to an example embodiment of the present inventive concept; and
FIGS. 4, 5, 6, 7, 8, 9, 10, 11, 12, and 13 are cross-sectional views illustrating the method of manufacturing the organic light emitting display device of FIG. 3.

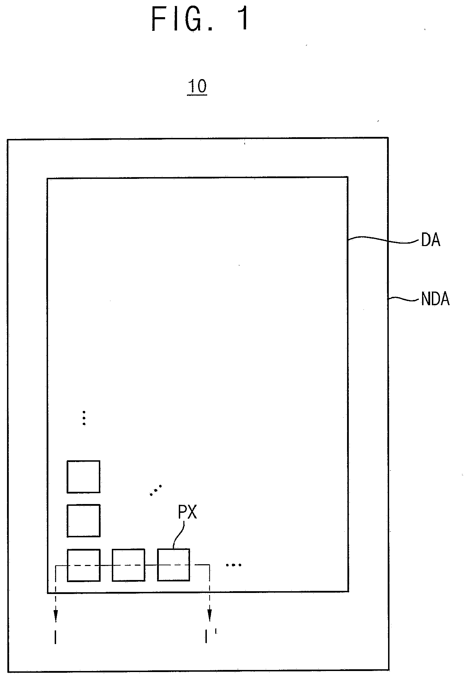

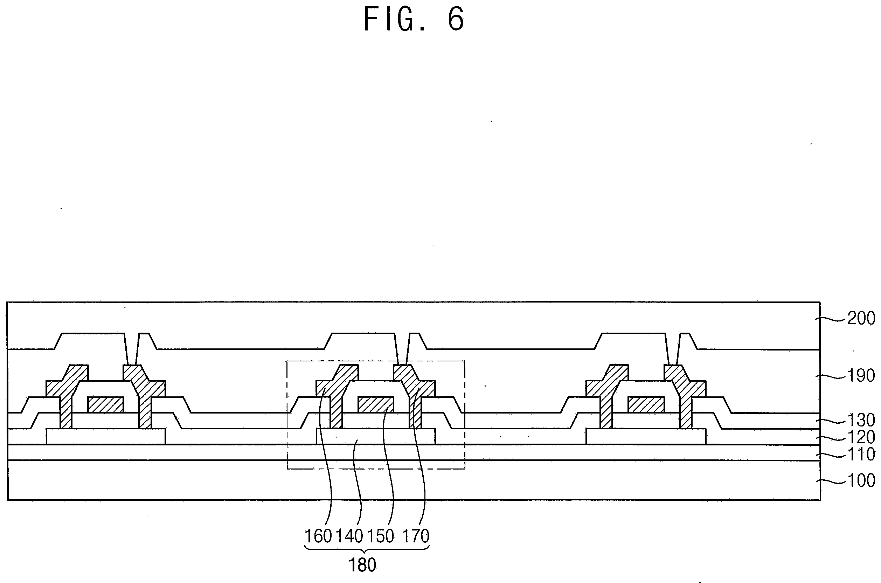

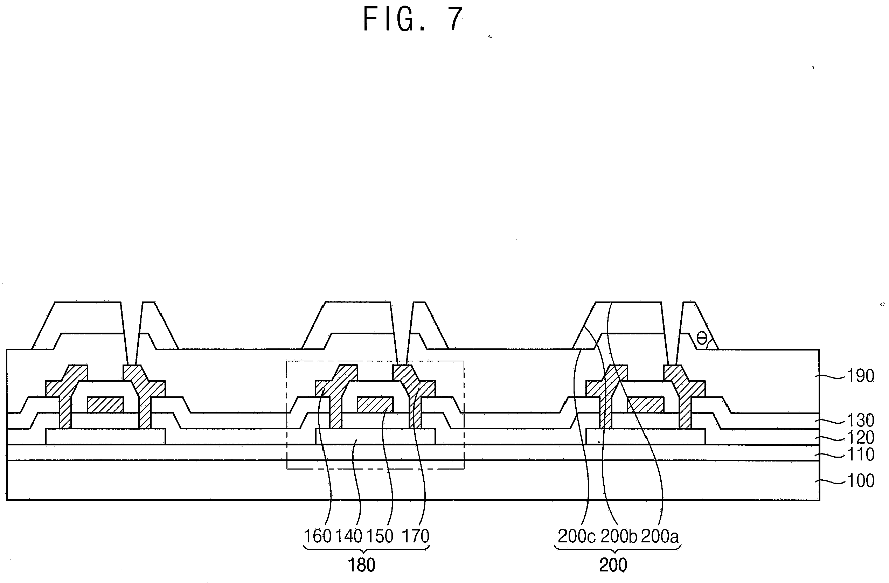

Since the drawings in FIGS. 1-13 are intended for illustrative purposes, the elements in the drawings are not necessarily drawn to scale. For example, some of the elements may be enlarged or exaggerated for clarity purpose.

### DETAILED DESCRIPTION OF THE EMBODIMENTS

Hereinafter, example embodiments of the present inventive concept will be explained in detail with reference to the accompanying drawings.

FIG. 1 is a plan view illustrating an organic light emitting display device according to an example embodiment of the present inventive concept.

Referring to FIG. 1, the organic light emitting display device 10 may include a display area DA and a non-display area NDA. A plurality of pixels PX for displaying images may be disposed in the display area DA, and a power supply unit for driving the pixels PX may be disposed in the non-display area NDA. In an example embodiment of the present inventive concept, a plurality of pixels PX may be arranged in a matrix shape, but the present inventive concept is not limited thereto. For example, the plurality of pixels may be arranged in a pentile matrix shape, or a diamond shape. The power supply unit may provide a power to pixels PX, and thus the pixels PX may emit light. For example, in the display area DA, power wires connected to the power supply unit may be disposed at regular intervals along a row direction or a column direction, and transistors may be disposed between the power wires and the pixels PX. As the transistors connected to the power wires are turn on, the power may be provided to the pixels PX. The display area DA may provide a predetermined image using light emitted from the pixels PX. For example, in the display area DA, a plurality of pixels PX, for example, an array of pixels PX, may be arranged, and the predetermined image may be displayed via the array of pixels PX.

In an example embodiment of the present inventive concept, each of the pixels PX may emit a red light, a green light, or a blue light. In an example embodiment of the present inventive concept, the pixels PX may emit a white light. When the pixels PX emit the white light, a color filter layer may be further disposed in the display area DA. The color filter layer may include a red color filter, a green color filter, and a blue color filter, and the white light emitted from the pixels PX may be converted into the red light, the green light, or the blue light by passing through the corresponding color filter. The color filters may be arranged by taking into account the colors of light beams emitted by the pixels PX of a display panel. Thus, the desired color may be realized by filtering the light emitted by each of the pixels PX with the color filter.

For the color of the light emitted from the pixels PX or the color of the light passing through the color filter to be clearly recognized by a user, a light incident to the organic light emitting display device 10 from an outside (e.g., an external light) and reflected from the pixels (for example, reflected from a first electrode and/or a second electrode) should be reduced. For example, if the external light reflected by the first electrode is visible to the user, it may interfere the performance of the pixels PX arranged in the display area, and thus should be minimized.

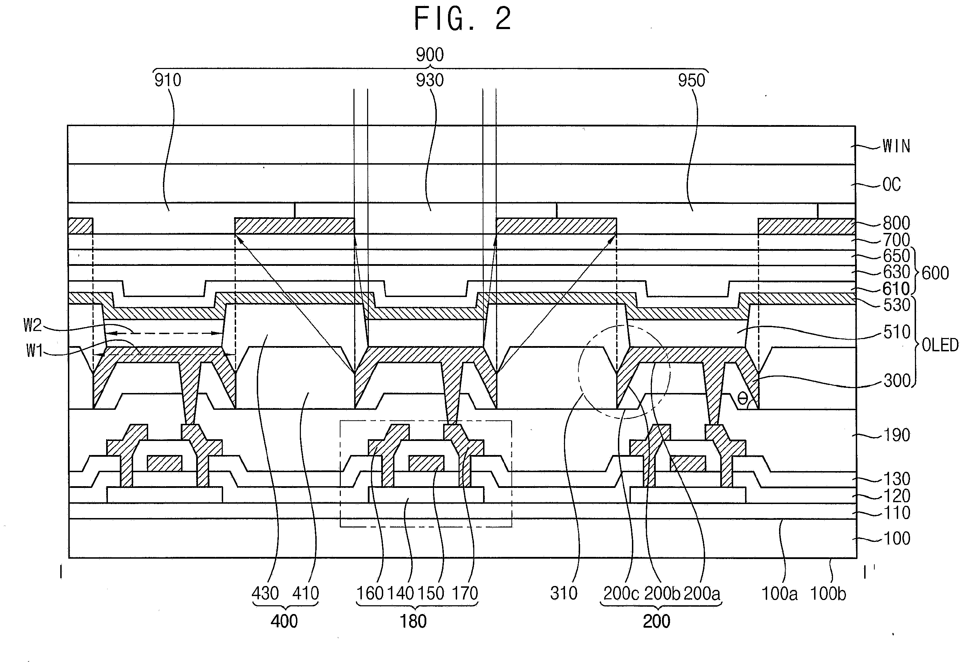

FIG. 2 is a cross-sectional view taken along line I-I' of FIG. 1.

Referring to FIG. 2, the organic light emitting display device 10 may include a substrate 100, a buffer layer 110, a first insulation layer 120, a second insulation layer 130, a protecting layer 190, a via pattern 200, an organic light emitting diode OLED, a pixel defining layer 400, a thin film encapsulation layer 600, a sensing structure 700, a black matrix 800, a color filter layer 900, an overcoating layer OC, and a cover window WIN. The organic light emitting diode OLED may include a first electrode 300, a light emitting layer 510, and a second electrode 530, and the pixel defining layer 400 may include a first pixel defining layer 410 and a second pixel defining layer 430. Each of the pixels PX may emit, for example, a red light, a green light, or a blue light, or may emit a red light, a green light, a blue light, or a white light, via the organic light-emitting diode OLED, for example via the light emitting layer 510 of the organic light-emitting diode OLED.

The substrate 100 may include a top surface 100a and a bottom surface 100b. Components included in the organic light emitting display device 10 may be disposed on the top surface 100a of the substrate 100, and the bottom surface 100b may face the top surface 100a.

The substrate 100 may include a transparent material or an opaque material. In an example embodiment of the present inventive concept, the substrate 100 may include a flexible plastic substrate. The flexible plastic substrate may be a polyimide substrate, and the substrate 100 may have a structure in which at least one polyimide layer and at least one barrier layer are alternately stacked. In an example embodiment of the present inventive concept, the substrate 100 may include a quartz substrate, a glass substrate, or the like. For example, the substrate 100 may include a glass material and/or a polymer resin, and may have a single layer structure or a multi-layer structure.

The buffer layer 110 may be disposed on the substrate 100, and may include an inorganic insulating material such as, for example, silicon oxide (SiOₓ), silicon oxynitride (SiON), and/or silicon nitride (SiNₓ). The buffer layer 110 may prevent a phenomenon in which metal atoms or impurities are diffused from the substrate 100 to a transistor 180. In an example embodiment of the present inventive concept, the buffer layer 110 may adjust a heat transfer rate during a crystallization process for forming an active pattern 140 of the transistor 180, so that the active pattern 140 is uniformly formed.

The transistor 180 may include the active pattern 140, a gate electrode 150, a source electrode 160, and a drain electrode 170. The active pattern 140 may include source and drain areas where impurities are doped and a channel area between the source area and the drain area. For example, the source and drain areas may be doped with an n-type dopant or a p-type dopant. In an example embodiment of the present inventive concept, the active pattern 140 may include an amorphous silicon (a-Si), a polycrystalline silicon (p-Si), or the like. Alternatively, in an example embodiment of the present inventive concept, the active pattern 140 may include an oxide of at least one of, for example, indium (In), gallium (Ga), tin (Sn), zirconium (Zr), vanadium (V), hafnium (Hf), cadmium (Cd), germanium (Ge), chromium (Cr), titanium (Ti), or zinc (Zn).

The first insulation layer 120 may be disposed on the buffer layer 110, and may include an inorganic insulating material such as, for example, silicon oxide (SiOₓ), silicon nitride (SiNₓ), silicon oxynitride (SiON), aluminum oxide (Al₂O₃), titanium oxide (TiO₂), tantalum oxide (Ta₂O₅), lanthanum oxide (La₂O₃), zirconium oxide (ZrO₂), or hafnium oxide (HfO₂). For example, the first insulation layer 120 may cover the active pattern 140 on the buffer layer 110, and may be disposed to have the same thickness along a profile of the active pattern 140.

The gate electrode 150 may be disposed on the first insulation layer 120, and may overlap with the active pattern 140. In general, the term "overlap" means overlapping in a direction perpendicular to the top surface of the substrate. The gate electrode 150 may include, for example, a metal, an alloy, a conductive metal oxide, a transparent conductive material, or the like. In an example embodiment of the present inventive concept, the gate electrode 150 may include a single layer or a multi-layer including at least one of, for example, silver (Ag), molybdenum (Mo), aluminum (Al), copper (Cu), chromium (Cr), nickel (Ni), titanium (Ti), or an alloy thereof.

The second insulation layer 130 may be disposed on the gate electrode 150 and the first insulation layer 120, and may include an inorganic insulating material such as, for example, silicon oxide (SiOₓ), silicon nitride (SiNₓ), silicon oxynitride (SiON), aluminum oxide (Al₂O₃), titanium oxide (TiO₂), tantalum oxide (Ta₂O₅), or hafnium oxide (HfO₂). For example, the second insulation layer 130 may cover the gate electrode 150 on the first insulation layer 120, and may be disposed to have the same thickness along a profile of the gate electrode 150.

The source electrode 160 and the drain electrode 170 may be disposed on the second insulation layer 130. The source electrode 160 may be connected to the source area of the active pattern 140 through a first contact hole formed in the first and second insulation layers 120 and 130. The drain electrode 170 may be connected to the drain area of the active pattern 140 through a second contact hole formed in the first and second insulation layers 120 and 130. In an example embodiment of the present inventive concept, ach of the source electrode 160 and the drain electrode 170 may include a conductive material including, for example, silver (Ag), molybdenum (Mo), aluminum (Al), copper (Cu), chromium (Cr), nickel (Ni), titanium (Ti), an alloy thereof, etc., and may be a multi-layer or a single layer including the aforementioned materials.

The protecting layer 190 may be disposed on the second insulation layer 130, the source electrode 160, and the drain electrode 170. For example, the protecting layer 190 may cover the source and drain electrodes 160 and 170 on the second insulation layer 130, and may be disposed to have the same thickness along a profile of the source and drain electrodes 160 and 170. The protecting layer 190 may be disposed between the substrate 100 and the via pattern 200, so that the protecting layer 190 prevents unnecessary contacts between wires formed on the substrate 100 and the first electrode 300 of the organic light emitting diode OLED.

In an example embodiment of the present inventive concept, the protecting layer 190 may include an inorganic material such as, for example, silicon nitride (SiNₓ), silicon oxide (SiOₓ), or the like. In this case, the protecting layer 190 may have a single layer structure, or may have a multi-layer structure including at least two insulation layers. Otherwise, the protecting layer 190 may include an organic material such as, for example, a photoresist, a polyimide resin, a polyamide resin, or the like. In this case, the protecting layer 190 may be a planarization insulating layer, and an upper surface thereof may include an approximately flat surface. In an example embodiment of the present inventive concept, the protecting layer 190 may include a material the same as that of the via pattern 200.

The via pattern 200 may include a first surface 200a, a second surface 200b, and a third surface 200c. The first surface 200a may be substantially parallel to the top surface 100a of the substrate 100. The second surface 200b may be located at both sides of the first surface 200a, and may be inclined at a predetermined angle θ with respect to the top surface 100a of the substrate 100. The third surface 200c may be opposite to the first surface 200a. For example, the third surface 200c may be a bottom surface of the via pattern 200, and may also be a portion of a top surface of the protecting layer 190. Since the via pattern 200 includes the second surface 200b, the first electrode 300 formed on the via pattern 200 may overlap with the second surface 200b. In addition, since the second surface 200b is inclined at the predetermined angle θ, the first electrode 300 may include an inclined portion 310, and an end portion of the inclined portion 310 may be toward the substrate 100. Alternatively, the top surface 100a of the substrate 100 and the first surface 200a may not be parallel to each other.

In an example embodiment of the present inventive concept, the first electrode 300 may be disposed on the substrate 100, and may include a horizontal top surface in parallel with the top surface 100a of the substrate 100, and two inclined side surfaces respectively located at two opposite sides of the horizontal top surface of the first electrode 300. Each of the two inclined side surfaces may be inclined with respect to the top surface 100a of the substrate 100 at a predetermined angle θ, and may extend from the horizontal top surface of the first electrode 300 with an end portion toward the substrate 100.

In an example embodiment of the present inventive concept, a length of the first surface 200a may be shorter than a length of the third surface 200c. In this case, a cross-sectional shape of the via pattern 200 may be a trapezoidal shape. However, the cross-sectional shape of the via pattern 200 is not limited thereto. The cross-sectional shape of the via pattern 200 may include various shapes for allowing the end portion of the inclined portion 310 of the first electrode 300 to extend toward the substrate 100. In addition, each of the first to third surfaces 200a, 200b, and 200c of the via pattern 200 may be implemented as a straight line or a curved line. For example, since the protecting layer 190 may be disposed to have the same thickness along a profile of the source and drain electrodes 160 and 170, the third surface 200c of the via pattern may have a portion located above the source and drain electrodes 160 and 170 protruding upward. Alternatively, the protecting layer 190 may have a planarized top surface. In this case, the third surface 200c of the via pattern may have a flat surface without the protruding portion.

The via pattern 200 may include an organic material such as, for example, a photoresist, a polyimide resin, a polyamide resin, a siloxane resin, or the like, or may include an inorganic material such as, for example, silicon nitride (SiNₓ), silicon oxide (SiOₓ), or the like. In this case, the via pattern 200 may be a single layer structure, or may be a multi-layer structure including at least two insulation layers.

The organic light emitting diode OLED may include the first electrode 300, the light emitting layer 510, and the second electrode 530, with the light emitting layer 510 interposed between the first electrode 300 and the second electrode 530.

The first electrode 300 may be disposed on the via pattern 200. The first electrode 300 may be a single layer structure or a multi-layer structure including, for example, a metal film, an alloy film, a metal nitride film, a conductive metal oxide film, and/or a transparent conductive material film. For example, the first electrode 300 may include, for example, silver (Ag), an alloy containing Ag, Aluminum (Al), an alloy containing Al, aluminum nitride (AlN), tungsten (W), tungsten nitride (WN), copper (Cu), nickel (Ni), chromium (Cr), chromium nitride (CrN), molybdenum (Mo), an alloy containing Mo, titanium (Ti), tantalum (Ta), platinum (Pt), scandium (Sc), indium tin oxide (ITO), indium zinc oxide (IZO), or the like.

In an example embodiment of the present inventive concept, the first electrode 300 may include a reflective electrode. In this case, the first electrode 300 may include a reflective material. For example, the first electrode 300 may include silver (Ag), the alloy containing silver (Ag), aluminum (Al), copper (Cu), platinum (Pt), or the like. When the first electrode 300 includes the reflective electrode, the external light may be reflected from the first electrode 300.

The first electrode 300 may be disposed on the first surface 200a and the second surface 200b of the via pattern 200 along a profile of the via pattern 200. Accordingly, the first electrode 300 may be defined as a central portion overlapping with the first surface 200a, and the inclined portion 310 overlapping with the second surface 200b. In an example embodiment of the present inventive concept, the inclined portion 310 of the first electrode 300 may overlap with a part of the second surface 200b. In an example embodiment of the present inventive concept, the inclined portion 310 of the first electrode 300 may overlap with all of the second surface 200b. In an example embodiment of the present inventive concept, the first electrode 300 may overlap with the first surface 200a, the second surface 200b, and the protecting layer 190. In an example embodiment of the present inventive concept, the first electrode 300 may be disposed on only one surface of the second surface 200b located at both sides of the first surface 200a, and may not be disposed on the other surface.

The central portion of the first electrode 300 may overlap with the first surface 200a substantially parallel to the top surface 100a, and the inclined portion 310 may overlap with the second surface 200b inclined at the predetermined angle θ with respect to the top surface 100a. The central portion of the first electrode 300 disposed on the first surface 200a may be disposed to be substantially parallel to the top surface 100a. For example, the horizontal top surface of the central portion of the first electrode 300 may be substantially parallel to the top surface 100a of the substrate. The inclined portion 310 of the first electrode 300 disposed on the second surface 200b may be inclined with the predetermined angle θ with respect to the top surface 100a. Accordingly, the end portion of the inclined portion 310 overlapping with the second surface 200b may be toward the substrate 100. For example, the two inclined side surfaces located at two opposite sides of the horizontal top surface of the first electrode 300 may each be inclined with respect to the top surface 100a of the substrate 100 at a predetermined angle θ. The inclined portion 310 of the first electrode 300 may also include a vertical side surface or a side surface with small inclination (with respect to the vertical direction) extending from the inclined side surface.

The predetermined angle θ at which the second surface 200b of the via pattern 200 is inclined with respect to the top surface 100a of the substrate 100 (i.e., an inclination angle of the inclined portion 310 of the first electrode 300 with respect to the top surface 100a) may be set in various ways in consideration of a thickness of the via pattern 200, a thickness of the first electrode 300, a width of the black matrix 800, a thickness of the organic light emitting display device 10, and the like. For example, the spread range of the reflected light may be determined by the area size of the inclined side surface of the first electrode 300, and the direction of the reflected light may be determined by the inclination angle, for example, the predetermined angle θ, of the inclined side surface.

In an example embodiment of the present inventive concept, the predetermined angle θ may be set such that the external light reflected from the inclined portion 310 is incident on the black matrix 800 that blocks a light. For example, the predetermined angle θ may be set such that the external light reflected from each of the two inclined side surfaces of the first electrode 300 is incident on the black matrix 800. Therefore, the external light may be reflected from the inclined portion 310 and then the external light may be incident on the black matrix 800, so that a color of a light emitted from the light emitting layer 510 is more clearly seen by the user.

In an example embodiment of the present inventive concept, the predetermined angle θ may be set an acute angle. For example, the predetermined angle θ may be greater than about 30 degrees and less than about 60 degrees.

The pixel defining layer 400 may be disposed on the via pattern 200 on which the first electrode 300 is disposed and the protecting layer 190. The pixel defining layer 400 may include an opening which is exposing a part of the first electrode 300. For example, the pixel defining layer 400 may cover an edge of the first electrode 300. The light emitting layer 510 may be disposed in the opening, and an emitting area and a non-emitting area of the display area DA may be defined by the opening. For example, an area in which the opening of the pixel defining layer 400 is located may correspond to the emitting area, and an area in which the pixel defining layer 400 is disposed may correspond to the non-emitting area. The pixel defining layer 400 may be disposed between two adjacent first electrodes 300, and may include two or more layers with each one including an organic insulating material, an inorganic insulating material, or both.

In an example embodiment of the present inventive concept, the pixel defining layer 400 may include the first pixel defining layer 410 and the second pixel defining layer 430. The second pixel defining layer 430 may be disposed between the first pixel defining layer 410 and the second electrode 530 such that the first pixel defining layer 410 is spaced apart from the second electrode 530.

The first pixel defining layer 410 may be disposed on the protecting layer 190, and may include a first opening which is exposing a first part of the first electrode 300. Also, the first pixel defining layer 410 may be disposed on the first electrode 300, for example, at least on outer sidewalls of the first electrode 300. The first opening may have a first width W1. In an example embodiment of the present inventive concept, the first pixel defining layer 410 may contact and/or overlap with a part of the inclined portion 310 of the first electrode 300. For example, the vertical side surface or the side surface with small inclination (with respect to the vertical direction) of the first electrode 300 is in contact with the first pixel defining layer 410. In this case, when this side surface which is in contact with the first pixel defining layer 410 is slightly inclined, it is vertically overlapped by the first pixel defining layer 410. Accordingly, a remaining part of the inclined portion 310 which does not contact and/or overlap with the first pixel defining layer 410 may be exposed by the first opening.

In an example embodiment of the present inventive concept, the first pixel defining layer 410 may block the external light. In this case, the first pixel defining layer 410 may serve as a light shielding member. For example, the first pixel defining layer 410 may include a black pigment or a black dye. Therefore, the first pixel defining layer 410 may block the external light incident to the inclined portion 310 contacting and/or overlapping with the first pixel defining layer 410. In addition, wires disposed on the substrate 100 may not be visually recognized by the user because of the first pixel defining layer 410. For example, the external light may not be able to penetrate through the first pixel defining layer 410, and thus may not be reflected back by the wires disposed on the substrate 100.

The second pixel defining layer 430 may include a second opening which is exposing a second part of the first electrode 300. The second opening may have a second width W2. In an example embodiment of the present inventive concept, the second opening may overlap with the first opening, such that the second width W2 is smaller than the first width W1.

In an example embodiment of the present inventive concept, the second pixel defining layer 430 may overlap with a part of the inclined portion 310. Accordingly, a remaining part of the inclined portion 310 which does not overlap with the second pixel defining layer 430 may be exposed by the second opening. For example, the horizontal top surface of the first electrode 300 may be exposed by the second opening. In an example embodiment of the present inventive concept, the second pixel defining layer 430 may overlap with all of the inclined portion 310. For example, the second pixel defining layer 430 may overlap at least each of the two inclined side surfaces extending from the horizontal top surface and located at two opposite sides of the horizontal top surface of the first electrode 300. In an example embodiment of the present inventive concept, the second pixel defining layer 430 may overlap with a part of the central portion of the first electrode 300.

In an example embodiment of the present inventive concept, the second pixel defining layer 430 may be disposed on the first pixel defining layer 410, and may be interposed between the first pixel defining layer 410 and the second electrode 530. Therefore, the second width W2 of the second opening may be smaller than the first width W1 of the first opening.

A pixel defining layer of the conventional organic light emitting display device may overlap with a first electrode. The pixel defining layer of the conventional organic light emitting display device includes a black pigment or a black dye, and the black pigment or the black dye includes a conductive material such as copper (Cu). The first electrode and a second electrode of the conventional organic light emitting display device are shorted to each other by the conductive material.

To prevent an accident such as the short, the second pixel defining layer 430 may be interposed between the first pixel defining layer 410 and the second electrode 530. As the second pixel defining layer 430 is disposed as described above, the first pixel defining layer 410 and the second electrode 530 may be spaced apart from each other.

The second pixel defining layer 430 may include an organic insulating material such as, for example, a polyimide resin (particularly, a photosensitive polyimide resin ("PSPI")), a photoresist, a polyacrylic resin, or an acrylic resin, or may include an inorganic insulating material such as, for example, silicon oxide (SiOₓ), or silicon nitride (SiNₓ). In an example embodiment of the present inventive concept, the second pixel defining layer 430 may transmit the external light. Accordingly, the external light incident on the second pixel defining layer 430 may be transmitted passing through the second pixel defining layer 430, and may be reflected from the inclined portion 310 of the first electrode 300. For example, the external light transmitted passing through the second pixel defining layer 430 may be reflected by the inclined side surface extending from the horizontal top surface of the first electrode 300. In this case, the predetermined angle θ may be set such that the external light transmitted passing through the second pixel defining layer 430 after being reflected from the inclined portion 310 is incident on the black matrix 800 and may be blocked by the black matrix 800. Therefore, the predetermined angle θ may be set in various ways in consideration of not only the thickness of the via pattern 200, the thickness of the first electrode 300, the width of the black matrix 800, and the thickness of the organic light emitting display device 10 but also a thickness of the second pixel defining layer 430 and a refractive index of the second pixel defining layer 430. For example, for the black matrix 800 to sufficiently block the external light reflected from the inclined side surface of the first electrode 300, factors such as the spread range of the reflected light due to the area size of the inclined side surface of the first electrode 300, and the direction of the reflected light due to the inclination angle, for example, the predetermined angle θ, of the inclined side surface may also be considered.

The light emitting layer 510 may be disposed on the first electrode 300 exposed by the opening of the pixel defining layer 400. The light emitting layer 510 may have a multi-layer structure including an organic light emission layer, a hole injection layer, a hole transport layer, an electron transport layer, and an electron injection layer. Some of the layers may be optional. For example, in an example embodiment of the present inventive concept, the light emitting layer 510 may include the organic light emission layer, and at least one of the hole injection layer, the hole transport layer, the electron transport layer, or the electron injection layer.

In an example embodiment of the present inventive concept, the organic light emission layer may include light emission materials emitting a red light, a green light, or a blue light according to each pixel of the organic light emitting display device 10. For example, the organic light emission layer may include a fluorescent material or a phosphorescent material. The color filters may be arranged by taking into account the colors of light beams emitted by the pixels of the organic light emitting display device 10. Thus, the desired color may be realized by filtering the light emitted by each of the pixels with the color filter. In this case, the color filter layer 900 may include a red color filter 910, a green color filter 930, and a blue color filter 950 corresponding to the light emission materials. In an example embodiment of the present inventive concept, the organic light emission layer may emit a white light by mixing the light emission materials emitting the red light, the green light, and/or the blue light. In this case, each pixel may be divided by the color filter layer 900 including the red, green, and blue color filters 910, 930, and 950.

The second electrode 530 may be disposed on the pixel defining layer 400 and the light emitting layer 510. The second electrode 530 may be a continuous layer as a single body, and may be formed to cover a plurality of first electrodes 300. The second electrode 530 may be disposed in a single layer structure or a multi-layer structure including, for example, a metal film, an alloy film, a metal nitride film, a conductive metal oxide film, and/or a transparent conductive material film. For example, the second electrode 530 may include silver (Ag), an alloy containing Ag, aluminum (Al), an alloy containing Al, aluminum nitride (AlN), tungsten (W), tungsten nitride (WN), copper (Cu), nickel (Ni), chromium (Cr), chromium nitride (CrN), molybdenum (Mo), an alloy containing molybdenum (Mo), titanium (Ti), tantalum (Ta), platinum (Pt), scandium (Sc), indium tin oxide (ITO), indium zinc oxide (IZO) or the like.

In an example embodiment of the present inventive concept, the second electrode 530 may include a transparent electrode. In this case, the second electrode 530 may include a transparent material. For example, the second electrode 530 may include nickel (Ni), chromium (Cr), titanium (Ti), indium tin oxide (ITO), indium zinc oxide (IZO), or the like. When the second electrode 530 includes the transparent electrode, the external light may be transmitted passing through the second electrode 530, and may be reflected from the first electrode 300. As described above, the external light may also be transmitted passing through the second pixel defining layer 430 and reflected from the inclined portion 310 of the first electrode 300. The light emitted from the light emitting layer 510 may be transmitted passing through the second electrode 530 and the color filter layer 900.

The thin film encapsulation layer 600 may be disposed on the second electrode 530. The thin film encapsulation layer 600 may prevent a penetration of moisture and oxygen from the outside. In an example embodiment of the present inventive concept, the thin film encapsulation layer 600 may include a first inorganic layer 610 including an inorganic material, a second inorganic layer 650 including the inorganic material, and an organic layer 630 disposed between the first inorganic layer 610 and the second inorganic layer 650 and including an organic material. Since the first inorganic layer 610 may be formed along a structure thereunder, a top surface of the first inorganic layer 610 may not be flat. For example, the first inorganic layer 610 may be conformally formed on the structure thereunder. The organic layer 630 may cover the first inorganic layer 610, and may be planarized. For example, the organic layer 630 may be formed on the first inorganic layer 610 by a spin coating process.

The sensing structure 700 may be disposed on the thin film encapsulation layer 600. In an example embodiment of the present inventive concept, the sensing structure 700 may be disposed on the thin film encapsulation layer 600 so that some components (e.g., a sensing electrode) of the sensing structure 700 overlap with the thin film encapsulation layer 600. However, a structure in which the sensing structure 700 is disposed in the organic light emitting display device 10 is not limited thereto. The sensing structure 700 may detect a touch or an approach of the user. In an example embodiment of the present inventive concept, the sensing structure 700 may include multiple sensing electrodes. In this case, a capacitance is generated by the sensing electrodes, and the sensing structure 700 may detect the touch or the approach of the user by sensing a change in the capacitance. The sensing structure 700 may sense an external input according to a mutual capacitance method or a self-capacitance method. For example, the sensing structure 700 may obtain information on the external input through a change in capacitance between two sensing electrodes. In an example embodiment of the present inventive concept, the sensing structure 700 may detect the touch or the approach of the user through an electromagnetic induction method, a pressure sensing method, an infrared method, or the like.

The black matrix 800 may be disposed on the sensing structure 700. For example, the black matrix 800 may be disposed in the non-emitting area in which the pixel defining layer 400 is disposed. For example, the black matrix 800 may be formed in an area corresponding to the non-emitting area in which the first pixel defining layer 410 is disposed.

The black matrix 800 may include chromium (Cr), chromium oxide (Cr₂O₃), or the like. The black matrix 800 may be disposed in the non-emitting area, and may block light. Therefore, wires disposed in the non-emitting area may not be visually recognized by the user because of the black matrix 800.

The black matrix 800 may block the external light reflected from the inclined portion 310 of the first electrode 300. For example, the black matrix 800 may block the external light reflected from the inclined side surface of the first electrode 300. Accordingly, the external light reflected from the inclined portion 310 may not be emitted to the outside. Therefore, the color of the light emitted from the light emitting layer 510 may be more clearly seen by the user.

In an example embodiment of the present inventive concept, the first electrode 300 may overlap with the non-emitting area, and the black matrix 800 may not overlap with the first electrode 300. For example, a portion, such as the inclined side surface portion, of the first electrode 300 may overlap with the non-emitting area. The horizontal top surface of the first electrode 300 may overlap with the emitting area. Accordingly, a width of the black matrix 800 may be smaller than a width of a black matrix included in the conventional organic light emitting display device.

In the conventional organic light emitting display device, a black matrix needs to overlap with the end portion of the first electrode to block the external light reflected from an end portion of a first electrode disposed in the non-emitting area. As a result, a view angle of the conventional organic light emitting display device becomes narrow. Therefore, when the user views the conventional organic light emitting display device at an angle, the light emitted from the light emitting layer may not be seen by the user.

Since the organic light emitting display device 10 of the present inventive concept includes the inclined portion 310 having the predetermined angle θ, the external light reflected from the inclined portion 310 may be incident on the black matrix 800 that does not overlap with the first electrode 300, and may be blocked by the black matrix 800. For example, the black matrix 800 may block the external light reflected from the inclined side surfaces of the first electrode 300. Accordingly, the width of the black matrix 800 may be smaller than the width of the black matrix included in the conventional organic light emitting display device. As a result, the view angle of the organic light emitting display device 10 may become wide. Therefore, even when the user views the organic light emitting display device 10 at an angle, the light emitted from the light emitting layer 510 may be clearly seen by the user.

The color filter layer 900 may be disposed on the sensing structure 700 with the black matrix 800. The color filter layer 900 may partially overlap with the black matrix 800. The color of the light emitted from the light emitting layer 510 may be more clearly recognized as it passes through the color filter layer 900.

The color filter layer 900 may include a plurality of color filters 910, 930, and 950. Each of the color filters 910, 930, and 950 may transmit a light of a specific wavelength band and may block a light of another specific wavelength band. In other words, each of the color filters 910, 930, and 950 may be a wavelength selective optical filter that selectively transmits only a portion of wavelength bands of a light incident on each of the color filters 910, 930, and 950.

In an example embodiment of the present inventive concept, the color filters 910, 930, and 950 may include the red color filter 910, the green color filter 930, and the blue color filter 950. The red color filter 910 may only let red light through, the green color filter 930 may only let green light through, and the blue color filter 950 may only let blue light through. When the light emitting layer 510 emits the red light, the green light, and the blue light according to each pixel, the color filters 910, 930, and 950 may be disposed corresponding to each pixel. Otherwise, when the light emitting layer 510 emits the white light, the white light may be converted into respective color while passing through the color filters 910, 930, and 950. For example, the white light may be converted into the red color while passing through the red color filter 910, may be converted into the green color while passing through the green color filter 930, and may be converted into the blue color while passing through the blue color filter 950.

The overcoating layer OC and the cover window WIN may be disposed on the color filter layer 900. The overcoating layer OC may be formed of polyimide, acrylic, inorganic material, or the like. The overcoating layer OC may compensate for the overall height of the organic light emitting display device 10. Accordingly, a top surface of the overcoating layer OC may be a flat surface. The cover window WIN may include a glass or a plastic material. In addition, the cover window WIN may be formed as a single layer or may be a laminate in which a plurality of functional layers are stacked, so that components of the organic light emitting display device 10 are protected from an external impact.

Since the organic light emitting display device 10 does not include a polarizer, a weight and a thickness of the organic light emitting display device 10 may be reduced. In addition, as the polarizer is not included, the light emitted from the light emitting layer 510 may be visually recognized more brightly, and the deterioration of the light emitting layer 510 may be slow by reducing an amount of current supplied to the light emitting layer 510. Therefore, a lifetime of the light emitting layer 510 may be relatively increased. The organic light emitting display device 10 according to the present inventive concept may not include a phase retarder which also reduces the light emitted from the light emitting layer 510 to the user, and thus the light emitted from the light emitting layer 510 may be visually recognized more brightly.

Since the polarizer or the phase retarder blocks the external light, when the conventional organic light emitting display device does not include the polarizer and/or the phase retarder, a reflectivity of the external light is increased and a visibility is reduced in the conventional organic light emitting display device. However, since the organic light emitting display device 10 of the present inventive concept includes the inclined portion 310 of the first electrode 300, the external light may be reflected from the inclined portion 310, and may be incident on the black matrix 800 and blocked by the black matrix 800. For example, the black matrix 800 may block the external light reflected from the inclined side surfaces of the first electrode 300. Accordingly, the organic light emitting display device 10 may reduce the reflectivity of the external light even without including the polarizer and/or the phase retarder.

The organic light emitting display device 10 may further include a color conversion layer between the organic light emitting diode OLED and the color filter layer 900. The color conversion layer may convert the light (e.g., a white light or a blue light) emitted from the light emitting layer 510 of the organic light emitting diode OLED into a transmitted light having a color different from the light emitted from the light emitting layer 510. The color conversion layer may include wavelength converting particles that convert a wavelength of at least a part of incident light. For example, the wavelength converting particle may include a first wavelength converting particle that converts an incident light having a specific wavelength into a light having a first wavelength and emits it, and a second wavelength converting particle that converts an incident light having a specific wavelength into a light having a second wavelength and emits it.

In an example embodiment of the present inventive concept, the color conversion layer may include first to third color conversion patterns. In detail, the first color conversion pattern may convert the light emitted from the light emitting layer 510 into a first transmitted light having a color different from the color of the light emitted from the light emitting layer 510. The second color conversion pattern may convert the light emitted from the light emitting layer 510 into a second transmitted light having a color different from the colors of the light emitted from the light emitting layer 510 and the first transmitted light. The third color conversion pattern may convert the light emitted from the light emitting layer 510 into a third transmitted light having a color different from the colors of the light emitted from the light emitting layer 510, the first transmitted light, and the second transmitted light. Alternatively, the third color conversion pattern may convert the light emitted from the light emitting layer 510 into a third transmitted light (e.g., a blue light) having a color the same as the color of the light emitted from the light emitting layer 510.

The color conversion layer may include a color conversion material such as a quantum dot or a phosphor. A quantum dot may have a core-shell structure, and the core may include cadmium selenide (CdSe), zinc sulfide (ZnS), magnesium selenide (MgSe), or the like. The phosphor may include strontium silicon oxide (SrₓSiO_{y}), strontium silicon nitride (SrₓSi_{y}N_{z}), butyl acrylate monomer (BAM), sialon (SiAlON), or the like.

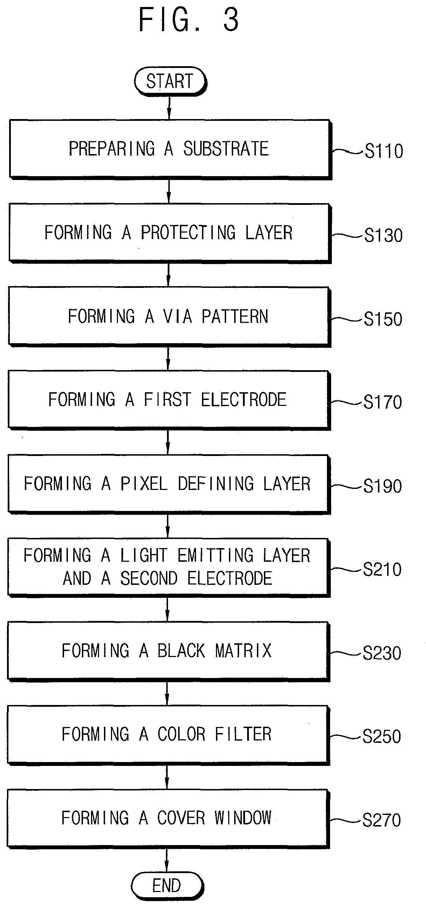

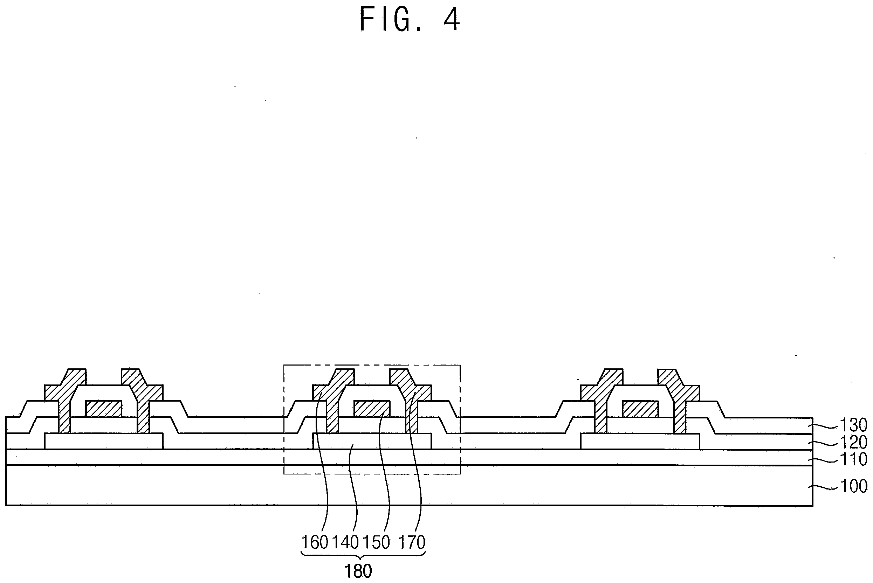

FIG. 3 is a flowchart illustrating a method of manufacturing an organic light emitting display device according to an example embodiment of the present inventive concept, and FIGS. 4, 5, 6, 7, 8, 9, 10, 11, 12, 13 are cross-sectional views illustrating the method of manufacturing the organic light emitting display device of FIG. 3

Referring to FIGS. 3 and 4, a substrate 100 on which a transistor 180 is formed may be prepared (S110). First, the substrate 100 may be provided. A buffer layer 110 may be formed on the substrate 100, an active pattern 140 may be formed on the buffer layer 110, and a first insulation layer 120 may be formed on the buffer layer 110 and the active pattern 140. The active pattern 140 may be formed by forming an active layer on the buffer layer 110, and then patterning the active layer to form the active pattern 140. Thereafter, a gate electrode 150 may be formed on the first insulation layer 120, and a second insulation layer 130 may be formed on the first insulation layer 120 and the gate electrode 150. After first and second contact holes are formed in the first and second insulation layers 120 and 130, a source electrode 160 and a drain electrode 170 may be formed. Each of the source and drain electrodes 160 and 170 may be connected to the active pattern 140 through the first and second contact holes. Portions of the active pattern 140 connected to the source and drain electrodes 160 and 170 may be doped with an n-type dopant or a p-type dopant.

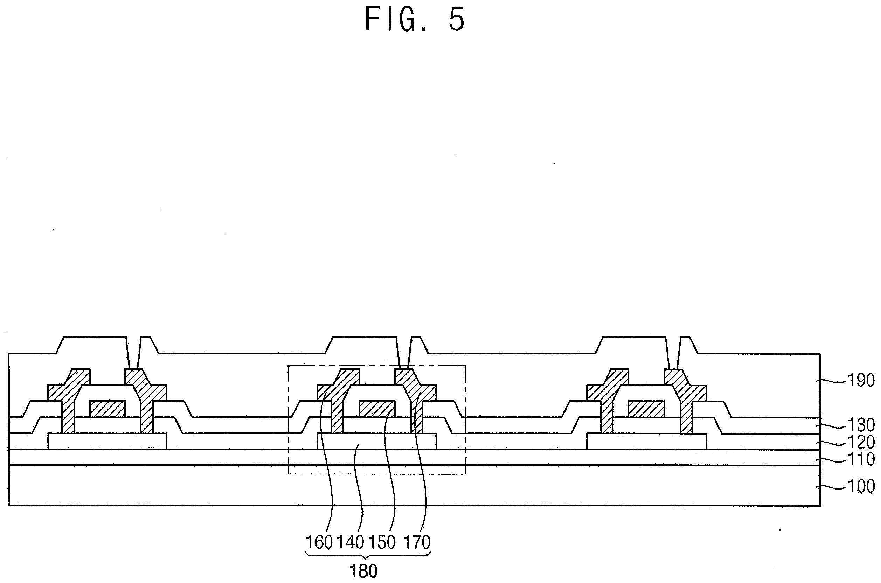

Referring to FIGS. 3 and 5, a protecting layer 190 may be formed to cover the source and drain electrodes 160 and 170 on the second insulation layer 130, and may be disposed to have the same thickness along a profile of the source and drain electrodes 160 and 170 (S 130). Thus, a portion of a top surface of the protecting layer 190 located above the source and drain electrodes 160 and 170 may protrude upward. A third contact hole exposing a part of the drain electrode 170 may be formed in the protecting layer 190, so that a conductive material may be formed in the third contact hole to electrically connect the drain electrode 170 and the first electrode 300 to be formed.

Referring to FIGS. 3, 6, and 7, a via pattern 200 may be formed on the protecting layer 190 (S150). For example, a material constituting the via pattern 200 may be coated on an entire surface to have a top surface parallel to a top surface 100a of the substrate 100, and then a second surface 200b and a fourth contact hole may be formed through a patterning process. The second surface 200b may be inclined at a predetermined angle θ, and a conductive material formed in the fourth contact hole may electrically connect the drain electrode 170 and the first electrode 300 to be formed. In an example embodiment of the present inventive concept, the fourth contact hole may be connected to the third contact hole, and the third and fourth contact holes may form one contact hole. The formation of the predetermined angle θ may take into consideration not only the thickness of the via pattern 200, but also many other parameters of other structures to be formed around the via pattern 200, so that the external light reflected by the first electrode 300 to be formed may be sufficiently blocked. The predetermined angle θ may be formed to have an acute angle. For example, the predetermined angle θ may be greater than about 30 degrees and less than about 60 degrees.

The fourth contact hole exposing a part of the protecting layer 190 and the drain electrode 170 may be formed in the via pattern 200, so that a conductive material formed in the fourth contact hole may electrically connect the drain electrode 170 and the first electrode 300 to be formed. In an example embodiment of the present inventive concept, the third contact hole formed in the protecting layer 190 and the fourth contact hole formed in the via pattern 200 may be formed separately. For example, the fourth contact hole of the via pattern 200 may be formed after forming the third contact hole. Through above process, unnecessary contacts between wires formed on the substrate 100 and the first electrode 300 to be formed may be prevented. However, the present inventive concept is not limited thereto. For example, the third and fourth contact holes may be formed after both the protecting layer 190 and the via pattern 200 are formed.

In an example embodiment of the present inventive concept, the patterning process may be a process which is selectively irradiating ultraviolet rays using a mask such as a halftone mask or a slit mask through a photolithographic process, and then forming a pattern through a dry or wet etching process. In detail, the halftone mask may include a light blocking region in which a light blocking pattern is formed, a light non-blocking region in which the light blocking pattern is not formed, and a semi-transmissive region in which a semi-transmissive pattern is formed to reduce an irradiation amount of the ultraviolet rays. The slit mask may include the light blocking region in which the light blocking pattern is formed and the light non-blocking region in which the light blocking pattern is not formed. The ultraviolet rays directed to the light blocking region may be blocked, the ultraviolet rays directed to the light non-blocking region may be transmitted, and the ultraviolet rays directed to the light non-blocking region may be transmitted only a part of amount of the ultraviolet rays. After the halftone mask or the slit mask is positioned on the via pattern 200, the pattern may be formed by irradiating the ultraviolet rays. Thereafter, the inclined second surface 200b of the via pattern 200 may be formed through the etching process after a development using developer.

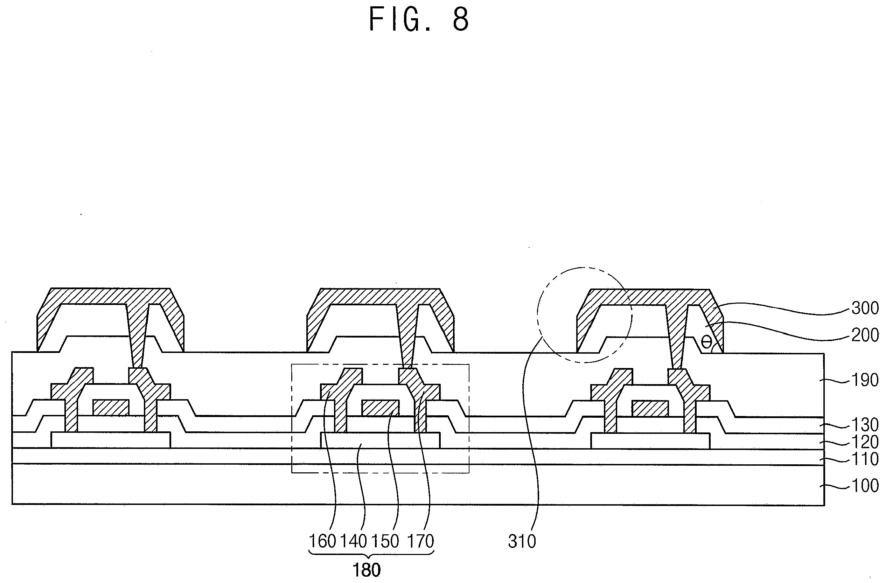

Referring to FIGS. 3 and 8, a first electrode 300 may be formed on the via pattern 200 (S170). Since the first electrode 300 is formed along a profile of the via pattern 200 including the second surface 200b, an inclined portion 310 of the first electrode 300 overlapping with the second surface 200b may have the predetermined angle θ and may be formed toward the substrate 100. For example, the two inclined side surfaces located at two opposite sides of the horizontal top surface of the first electrode 300 may each be inclined with respect to the top surface 100a of the substrate 100 at the predetermined angle θ.

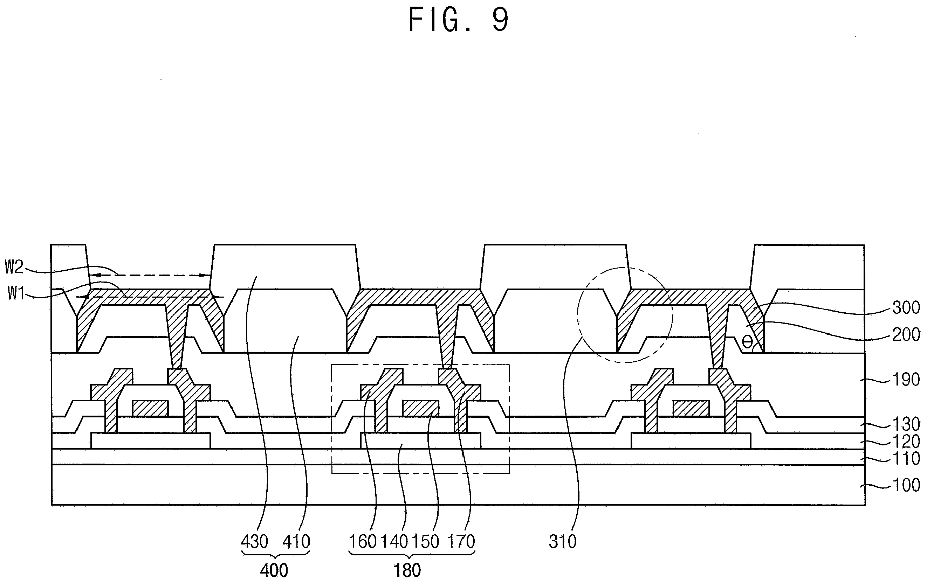

Referring to FIGS. 3 and 9, a pixel defining layer 400 may be formed on the protecting layer 190, the via pattern 200, and the first electrode 300 (S190). The pixel defining layer 400 may include an opening which is exposing a part of the first electrode 300.

In an example embodiment of the present inventive concept, the pixel defining layer 400 may include a first pixel defining layer 410 and a second pixel defining layer 430. The first opening which is exposing a part of the first electrode 300 may be formed in the first pixel defining layer 410 and the second opening which is overlapping with the first opening may be formed in the second pixel defining layer 430. The horizontal top surface of the first electrode 300 may be exposed by the second opening.

The second pixel defining layer 430 may be formed on the first pixel defining layer 410 on which the first opening is formed such that a second width W2 of the second opening is smaller than a first width W1 of the first opening. That is, the second pixel defining layer 430 may be formed on the first pixel defining layer 410 to cover the first pixel defining layer 410. Since the second pixel defining layer 430 covers the first pixel defining layer 410, the first pixel defining layer 410 may be spaced apart from the second electrode 530 to be formed. The second pixel defining layer 430 may overlap with all of the inclined portion 310 of the first electrode 300. For example, the second pixel defining layer 430 may overlap at least each of the two inclined side surfaces extending from the horizontal top surface and located at two opposite sides of the horizontal top surface of the first electrode 300.

The first and second openings of the first and second pixel defining layers 410 and 430 may be formed through the patterning process.

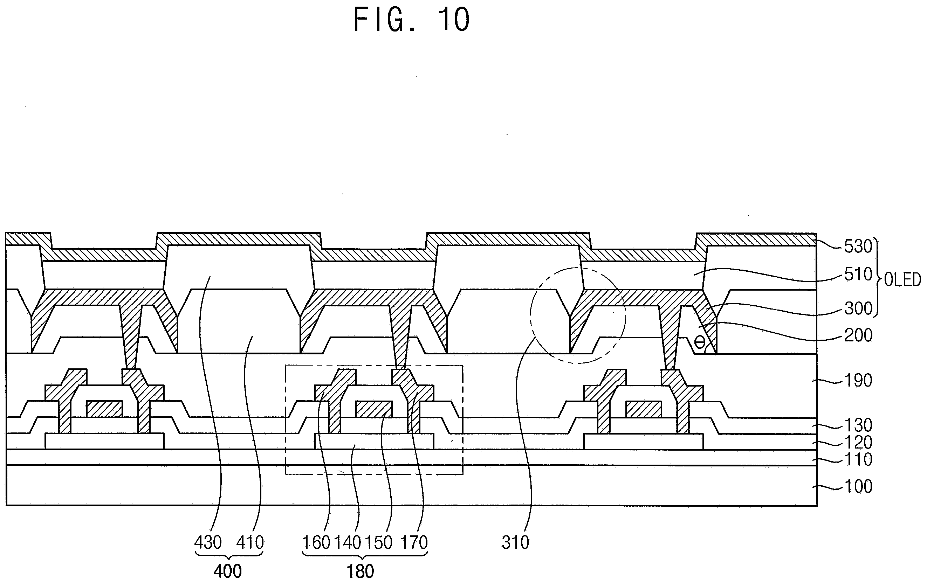

Referring to FIGS. 3 and 10, a light emitting layer 510 may be formed in the opening, for example, the second opening, of the pixel defining layer 400, and a second electrode 530 may be formed on the pixel defining layer 400 and the light emitting layer 510 (S210). In an example embodiment of the present inventive concept, all of the light emitting layer 510 may be formed of the same material to emit a light having the same color. For example, all of the light emitting layer 510 may emit a white light or a blue light. In an example embodiment of the present inventive concept, the light emitting layer 510 may be formed of a different material for each of the openings to emit light having different colors. For example, the light emitting layer 510 may emit a red light, a green light, or a blue light for each of the openings. The second electrode 530 may be formed over an entire area of the display area DA, and may be a continuous layer as a single body formed to cover a plurality of first electrodes 300.

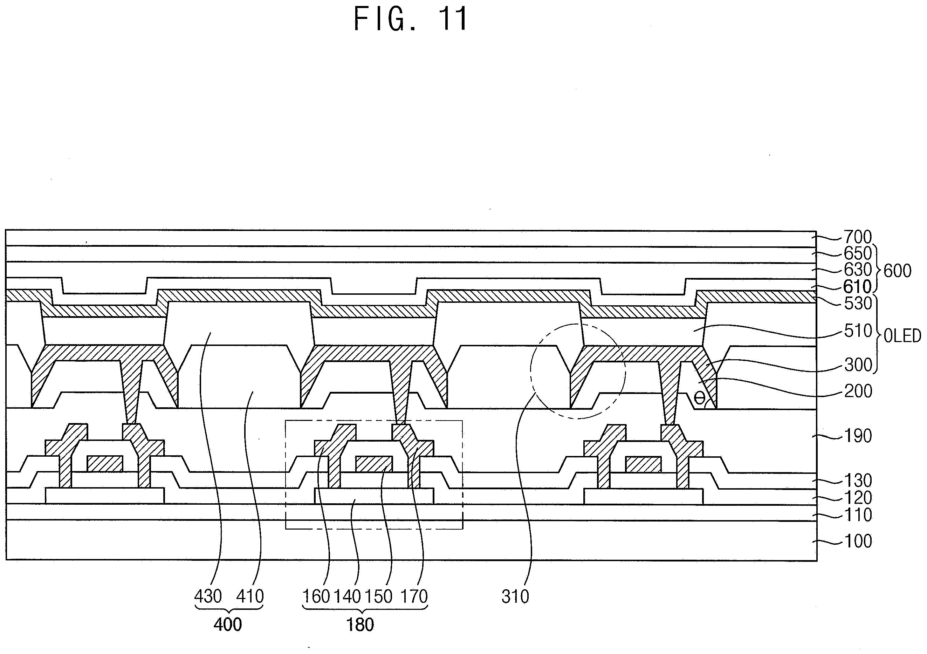

Referring to FIGS. 3 and 11, a thin film encapsulation layer 600 and a sensing structure 700 may be formed on the second electrode 530. The thin film encapsulation layer 600 may be formed in order of a first inorganic layer 610, an organic layer 630, and a second inorganic layer 650. The first inorganic layer 610 may be conformally formed on the second electrode 530. The organic layer 630 may be formed to cover the first inorganic layer 610, and may be planarized. The sensing structure 700 may be formed on the second inorganic layer 650.

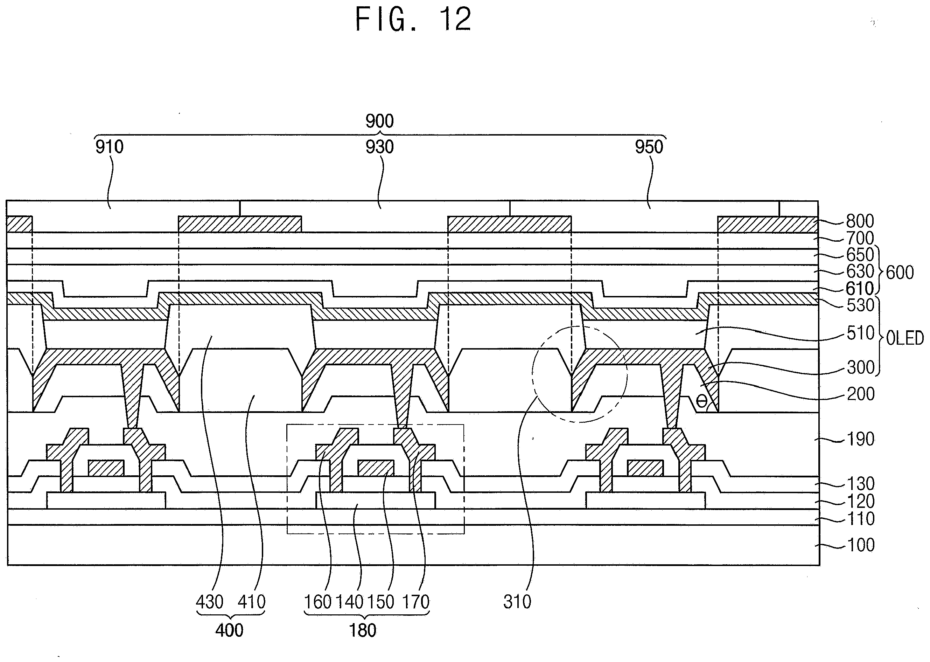

Referring to FIGS. 3 and 12, a black matrix 800 may be formed on the sensing structure 700 (S230). The black matrix 800 may be formed corresponding to a non-emitting area in which the pixel defining layer 400 is disposed. For example, the black matrix 800 may be formed in an area corresponding to a non-emitting area in which the first pixel defining layer 410 is disposed. In an example embodiment of the present inventive concept, the black matrix 800 may be formed so as not to overlap with the first electrode 300. Subsequently, a color filter layer 900 may be formed on the sensing structure 700 and the black matrix 800 (S250). In an example embodiment of the present inventive concept, the color filter layer 900 may include a plurality of color filters 910, 930 and 950. Each of the color filters 910, 930, and 950 may transmit a light of a specific wavelength band and may block a light of another specific wavelength band. Although the color filter layer 900 overlaps with the black matrix 800 and is formed on the black matrix 800 in FIG. 12, the present inventive concept is not limited thereto. For example, the color filters 910, 930 and 950 may be formed correspondingly between the black matrix 800 arranged at regular intervals. Alternatively, part of the black matrix 800 may be overlapped by the color filter layer 900, and part of the black matrix 800 may not be overlapped by the color filter layer 900.

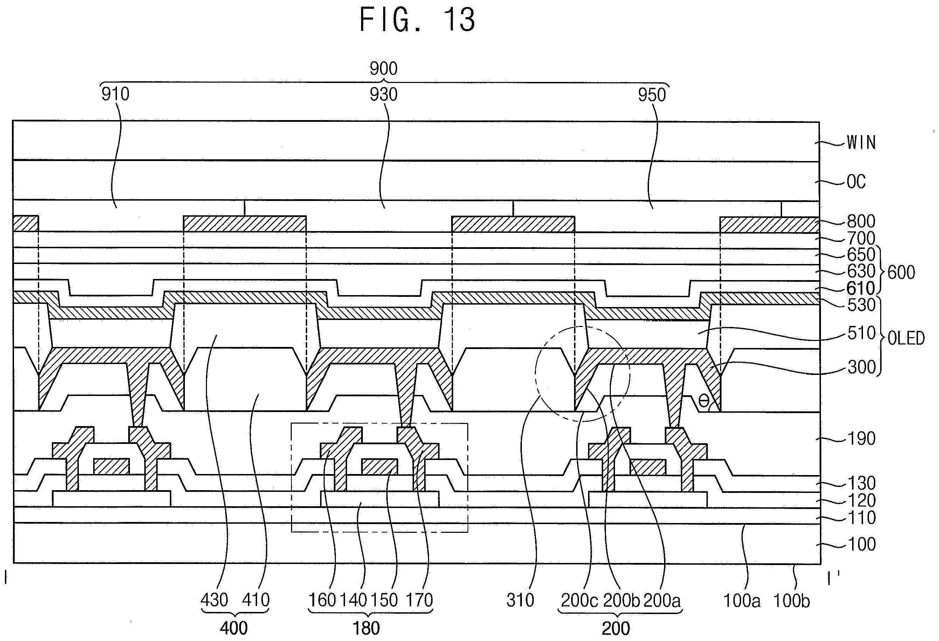

Referring to FIGS. 3 and 13, an overcoating layer OC and a cover window WIN may be formed on the color filter layer 900 (S270). Meanwhile, the organic light emitting display device 10 according to an example embodiment of the present inventive concept may not include a polarizer and/or a phase retarder as described above. Accordingly, the method of manufacturing the organic light emitting display device 10 may not include forming the polarizer and/or the phase retarder.

The present inventive concept may be applied to an organic light emitting display device and an electronic device using the organic light emitting display device. For example, the present inventive concept may be applied to a cellular phone, a smart phone, a video phone, a smart pad, a smart watch, a tablet PC, a car navigation system, a television, a computer monitor, a laptop, etc.

## Claims

1. An organic light emitting display device (10) comprising:
a substrate (100);
a via pattern (200) disposed on the substrate (100), the via pattern (200) including a first surface (200a) parallel to a top surface (100a) of the substrate (100) and a second surface (200b) located at both sides of the first surface (200a), the second surface (200b) being inclined with respect to the top surface (100a) of the substrate (100) at a predetermined angle (θ);
**characterized by**
a first electrode (300) disposed on the first and second surfaces (200a, 200b) of the via pattern (200), the first electrode (300) including an inclined portion (310) overlapping with the second surface (200b) of the via pattern (200), with an end portion of the inclined portion (310) being toward the substrate (100);
a light emitting layer (510) disposed on the first electrode (300);
a second electrode (530) disposed on the light emitting layer (510); and
a black matrix (800) located on the second electrode (530).

2. The organic light emitting display device (10) of claim 1, wherein the predetermined angle (θ) is set such that an external light reflected from the inclined portion (310) is incident on the black matrix (800).

3. The organic light emitting display device (10) of at least one of claims 1 or 2, wherein the predetermined angle (θ) is an acute angle.

4. The organic light emitting display device (10) of at least one of claims 1 to 3, wherein
the via pattern (200) further includes a third surface (200c) located opposite to the first surface (200a), and
a length of the first surface (200a) is shorter than a length of the third surface (200c).

5. The organic light emitting display device (10) of claim 4, wherein a cross-sectional shape of the via pattern (200) is a trapezoidal shape.

6. The organic light emitting display device (10) of at least one of claims 1 to 5, further comprising:
a first pixel defining layer (410) disposed on the first electrode (300),
wherein the first pixel defining layer (410) includes a first opening which is exposing a first part of the first electrode (300), and
the first pixel defining layer (410) absorbs an external light.

7. The organic light emitting display device (10) of claim 6, further comprising:
a second pixel defining layer (430) interposed between the first pixel defining layer (410) and the second electrode (530) such that the first pixel defining layer (410) is spaced apart from the second electrode (530),
wherein the second pixel defining layer (430) includes a second opening which is exposing a second part of the first electrode (300), and
the second pixel defining layer (430) transmits the external light.

8. The organic light emitting display device (10) of claim 7, wherein a width (w2) of the second opening is smaller than a width (W1) of the first opening.

9. The organic light emitting display device (10) of claim 8, wherein
the second pixel defining layer (430) overlaps with at least a part of the inclined portion (310) of the first electrode (300), and
the predetermined angle (θ) is set such that the external light reflected from the inclined portion (310) is incident on the black matrix (800) through the second pixel defining layer (430).

10. The organic light emitting display device (10) of at least one of claims 1 to 9, wherein the black matrix (800) does not overlap with the first electrode (300).

11. The organic light emitting display device (10) of at least one of claims 1 to 10, further comprising:
a color filter layer (900) overlapping with the light emitting layer (510), the color filter layer (900) disposed on the second electrode (530).

12. The organic light emitting display device (10) of claim 11, wherein the light emitting layer (510) emits a white light.

13. The organic light emitting display device (10) of at least one of claims 1 to 12, wherein
the first electrode (300) includes a reflective electrode, and
the second electrode (530) includes a transparent electrode.

14. The organic light emitting display device (10) of at least one of claims 1 to 13, further comprising:
a protecting layer (190) disposed between the substrate (100) and the via pattern (200), the protecting layer (190) including an inorganic insulation material.

15. An organic light emitting display device comprising:
a substrate (100);
a first electrode (300) disposed on the substrate (100) and including a horizontal top surface in parallel with a top surface (100a) of the substrate (100), and two inclined side surfaces respectively located at two opposite sides of the horizontal top surface (100a) of the first electrode (300),
**characterized in that**
each of the two inclined side surfaces (310) being inclined with respect to the top surface (100a) of the substrate (100) at a predetermined angle (θ) and extending from the horizontal top surface of the first electrode (300) with an end portion toward the substrate (100);
a light emitting layer (510) disposed on the first electrode (300);
a second electrode (530) disposed on the light emitting layer (510); and
a black matrix (800) located on the second electrode (530) and not overlapped with the first electrode (300).

16. The organic light emitting display device (10) of claim 15, wherein the predetermined angle (θ) is set such that an external light reflected from each of the two inclined side surfaces (310) of the first electrode (300) is incident on the black matrix (800).
